(19) Europäisches Patentamt
European Patent Office
Office européen des brevets

(11) EP 2 628 819 A1

(12) EUROPEAN PATENT APPLICATION
published in accordance with Art. 153(4) EPC

(43) Date of publication:
**21.08.2013 Bulletin 2013/34**

(21) Application number: **11832592.7**

(22) Date of filing: **13.10.2011**

(51) Int Cl.:
***C23C 14/48*** (2006.01) ***B32B 27/16*** (2006.01)
***C08J 7/00*** (2006.01) ***H01B 5/14*** (2006.01)
***H01B 13/00*** (2006.01)

(86) International application number:
**PCT/JP2011/073538**

(87) International publication number:
**WO 2012/050160 (19.04.2012 Gazette 2012/16)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.10.2010 JP 2010232358**

(71) Applicant: **LINTEC Corporation**
**Tokyo 173-0001 (JP)**

(72) Inventors:
- **NAGAMOTO Koichi**
  **Tokyo 173-0001 (JP)**
- **KONDO Takeshi**
  **Tokyo 173-0001 (JP)**
- **NAGANAWA Satoshi**
  **Tokyo 173-0001 (JP)**
- **SUZUKI Yuta**
  **Tokyo 173-0001 (JP)**

(74) Representative: **Albrecht, Thomas**
**Kraus & Weisert**
**Patent- und Rechtsanwälte**
**Thomas-Wimmer-Ring 15**
**80539 München (DE)**

# (54) TRANSPARENT CONDUCTIVE FILM, PRODUCTION METHOD THEREFOR, MATERIAL FOR ELECTRONIC DEVICE, AND ELECTRONIC DEVICE

(57) The present invention provides a transparent conductive film including a base layer, a gas barrier layer, and a transparent conductive layer, the gas barrier layer being formed of a material that includes at least oxygen atoms, carbon atoms, and silicon atoms, the gas barrier layer including an area (A) in which an oxygen atom content rate gradually decreases, and a carbon atom content rate gradually increases from a surface in a depth direction, the area (A) including a partial area (A1) and a partial area (A2), the partial area (A1) having an oxygen atom content rate of 20 to 55%, a carbon atom content rate of 25 to 70%, and a silicon atom content rate of 5 to 20%, based on a total content rate of oxygen atoms, carbon atoms, and silicon atoms, and the partial area (A2) having an oxygen atom content rate of 1 to 15%, a carbon atom content rate of 72 to 87%, and a silicon atom content rate of 7 to 18%, based on a total content rate of oxygen atoms, carbon atoms, and silicon atoms.

FIG.2

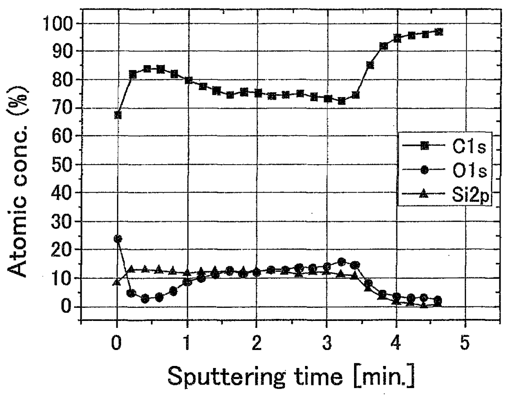


EP 2 628 819 A1

## Description

TECHNICAL FIELD

**[0001]** [0001] The invention relates to a transparent conductive film, a method for producing the same, an electronic device member that includes the transparent conductive film, and an electronic device that includes the electronic device member.

BACKGROUND ART

**[0002]** [0002] A transparent conductive film in which a transparent conductive layer is provided on a transparent plastic substrate has been known. Tin-doped indium oxide (ITO) has been mainly used as a material for forming the transparent conductive layer of the transparent conductive film. However, since indium is a trace metal, a zinc oxide-based conductive material has been proposed as a transparent conductive material that may substitute ITO. However, the zinc oxide-based conductive material has a problem in that a deterioration in sheet resistance easily occurs under high-temperature/high-humidity conditions as compared with ITO.

**[0003]** [0003] In order to solve the above problem, Patent Document 1 discloses a transparent conductor in which a silicon-doped zinc oxide film is formed on a hard coat layer provided on a plastic substrate. However, the transparent conductor disclosed in Patent Document 1 may show a deterioration in conductivity due to a decrease in crystallinity of the conductive material.

**[0004]** [0004] Patent Document 2 discloses a transparent heating element that includes a transparent conductive film of which the heat resistance is improved by adding a specific amount of gallium to zinc, for example. However, since it is necessary to add gallium to zinc under special conditions when forming the transparent conductive film of the transparent heating element disclosed in Patent Document 2, the production conditions are limited.

**[0005]** [0005] Patent Document 3 discloses a substrate that is provided with a transparent conductive film, and exhibits improved heat resistance as a result of providing a heat-resistant conductive layer having a high degree of oxidation. However, the technique disclosed in Patent Document 3 cannot control the sheet resistance under a high-temperature/high-humidity environment.

**[0006]** [0006] Non-patent Document 1 discloses a technique that controls the sheet resistance of a gallium oxide-zinc oxide-based transparent conductor under a high-temperature/high-humidity environment by increasing the amount of doping with gallium oxide, and setting the thickness of the conductor to 400 nm. However, since it is necessary to deposit the transparent conductor to a thickness of 400 nm, the productivity significantly deteriorates. Moreover, since a large amount of gallium oxide is used for doping, it is difficult to employ the technique disclosed in Non-patent Document 1 from the viewpoint of raw material cost.

RELATED-ART DOCUMENT

PATENT DOCUMENT

**[0007]** [0007]

Patent Document 1: JP-A-8-45352

Patent Document 2: JP-A-6-187833

Patent Document 3: JP-A-2009-199812

NON-PATENT DOCUMENT

**[0008]** [0008] Non-patent Document 1: APPLIED PHYSICS LETTERS 89, 091904 (2006)

SUMMARY OF THE INVENTION

TECHNICAL PROBLEM

**[0009]** [0009] The invention was conceived in view of the above situation. An object of the invention is to provide a transparent conductive film that exhibits an excellent gas barrier capability and excellent transparency, has low sheet resistance even under a high-temperature/high-humidity environment, and exhibits excellent bending resistance and

excellent conductivity, a method for producing the same, an electronic device member that includes the transparent conductive film, and an electronic device that includes the electronic device member.

SOLUTION TO PROBLEM

**[0010]** [0010] The inventors of the invention conducted extensive studies in order to achieve the above object. As a result, the inventors found that a transparent conductive film that includes a base layer, a gas barrier layer, and a transparent conductive layer, wherein the gas barrier layer is formed of a material that includes at least oxygen atoms, carbon atoms, and silicon atoms, and includes an area (A) in which the oxygen atom content rate gradually decreases, and the carbon atom content rate gradually increases from the surface in the depth direction, and the area (A) includes at least two partial areas having a specific oxygen atom content rate, a specific carbon atom content rate, and a specific silicon atom content rate, exhibits an excellent gas barrier capability and excellent transparency, has low sheet resistance even under a high-temperature/high-humidity environment, and exhibits excellent conductivity. The inventors also found that the gas barrier layer of such a transparent conductive film can be easily and efficiently formed by implanting ions into a polysilane compound-containing layer. These findings have led to the completion of the invention.
**[0011]** [0011] Several aspects of the invention provide the following transparent conductive film (see (1) to (9)), method for producing a transparent conductive film (see (10) to (12)), electronic device member (see (13)), and electronic device (see (14)).
**[0012]** [0012]

(1) A transparent conductive film including a base layer, a gas barrier layer, and a transparent conductive layer, the gas barrier layer being formed of a material that includes at least oxygen atoms, carbon atoms, and silicon atoms, the gas barrier layer including an area (A) in which an oxygen atom content rate gradually decreases, and a carbon atom content rate gradually increases from a surface in a depth direction,
the area (A) including a partial area (A1) and a partial area (A2), the partial area (A1) having an oxygen atom content rate of 20 to 55%, a carbon atom content rate of 25 to 70%, and a silicon atom content rate of 5 to 20%, based on a total content rate of oxygen atoms, carbon atoms, and silicon atoms, and the partial area (A2) having an oxygen atom content rate of 1 to 15%, a carbon atom content rate of 72 to 87%, and a silicon atom content rate of 7 to 18%, based on a total content rate of oxygen atoms, carbon atoms, and silicon atoms.

**[0013]** [0013]

(2) The transparent conductive film according to (1), wherein the area (A) is formed in a surface layer part of a palysilane compound-containing layer.
(3) The transparent conductive film according to (1) or (2), wherein the gas barrier layer is a layer obtained by implanting ions into a polysilane compound-containing layer.
(4) The transparent conductive film according to (2) or (3), wherein the polysilane compound includes a repeating unit represented by a formula (1),

**[0014]** [0014]

[Chemical Formula 1]

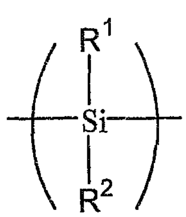

(1)

**[0015]** [0015] wherein $R^1$ and $R^2$ independently represent a hydrogen atom, an alkyl group, an alkenyl group, a cycloalkyl group, a cycloalkenyl group, an aryl group, a hydroxyl group, an alkoxy group, a cycloalkyloxy group, an aryloxy group, an aralkyloxy group, a substituted or unsubstituted amino group, a silyl group, or a halogen atom, provided that $R^1$ and $R^2$ may respectively be either identical or different.
**[0016]** [0016]

(5) The transparent conductive film according to (3), wherein the gas barrier layer is a layer obtained by implanting ions into a polysilane compound-containing layer by a plasma ion implantation method.
(6) The transparent conductive film according to (3), wherein the ions are obtained by ionizing at least one gas selected from a group consisting of hydrogen, nitrogen, oxygen, argon, helium, neon, xenon, krypton, a silicon compound, and a hydrocarbon.

**[0017]** [0017]

(7) The transparent conductive film according to (1) or (3), wherein the transparent conductive layer is formed of a conductive metal oxide.
(8) The transparent conductive film according to (7), wherein the conductive metal oxide is a zinc-based oxide.

**[0018]** [0018]

(9) The transparent conductive film according to (1) or (3), the transparent conductive film having a water vapor transmission rate at a temperature of 40°C and a relative humidity of 90% of less than 0.5 $g/m^2/day$.
(10) A method for producing the transparent conductive film according to any one of (2) to (9), the method including implanting ions into a polysilane compound-containing layer of a formed body that includes the polysilane compound-containing layer in its surface area.

**[0019]** [0019]

(11) The method according to (10), wherein the ions are obtained by ionizing at least one gas selected from a group consisting of hydrogen, oxygen, nitrogen, argon, helium, xenon, krypton, a silicon compound, and a hydrocarbon.
(12) The method according to (10), wherein the ions are implanted by a plasma ion implantation method.

**[0020]** [0020]

(13) An electronic device member including the transparent conductive film according to any one of (1) to (9).
(14) An electronic device including the electronic device member according to (13).

ADVANTAGEOUS EFFECTS OF THE INVENTION

**[0021]** [0021] The transparent conductive film according to one aspect of the invention exhibits an excellent gas barrier capability and excellent transparency, has low sheet resistance (shows a small change in sheet resistance) even under a high-temperature/high-humidity environment, and exhibits excellent bending resistance and excellent conductivity.
The transparent conductive film according to one aspect of the invention may suitably be used as an electronic device member for flexible displays, solar cells, and the like.
**[0022]** [0022] The method for producing a transparent conductive film according to one aspect of the invention can easily and efficiently produce the transparent conductive film according to one aspect of the invention that exhibits an excellent gas barrier capability and excellent transparency, has low sheet resistance (does not show a change in sheet resistance) even under a high-temperature/high-humidity environment, and exhibits excellent conductivity. The method can also inexpensively and easily achieve an increase in area of the transparent conductive film as compared with the case of forming an inorganic film.
**[0023]** [0023] Since the electronic device member according to one aspect of the invention exhibits an excellent gas barrier capability and excellent transparency, has low sheet resistance even under a high-temperature/high-humidity environment, and exhibits excellent conductivity, the electronic device member may suitably be used for electronic devices such as a display and a solar cell.

BRIEF DESCRIPTION OF DRAWINGS

**[0024]** [0024]

FIG. 1 is a view illustrating the layer configuration of a transparent conductive film according to one embodiment of the invention.
FIG. 2 is a view illustrating the oxygen atom content rate (%), the carbon atom content rate (%), and the silicon atom content rate (%) in the gas barrier layer of the transparent conductive film 1 of Example 1.
FIG. 3 is a view illustrating the oxygen atom content rate (%), the carbon atom content rate (%), and the silicon atom

content rate (%) in the gas barrier layer of the transparent conductive film 2 of Example 2.
FIG. 4 is a view illustrating the oxygen atom content rate (%), the carbon atom content rate (%), and the silicon atom content rate (%) in the gas barrier layer of the transparent conductive film 3 of Example 3.
FIG. 5 is a view illustrating the oxygen atom content rate (%), the carbon atom content rate (%), and the silicon atom content rate (%) in the gas barrier layer of the transparent conductive film 4 of Example 4.
FIG. 6 is a view illustrating the oxygen atom content rate (%), the carbon atom content rate (%), and the silicon atom content rate (%) in the gas barrier layer of the transparent conductive film 5 of Example 5.
FIG. 7 is a view illustrating the oxygen atom content rate (%), the carbon atom content rate (%), and the silicon atom content rate (%) in the gas barrier layer of the transparent conductive film 6 of Example 6.
FIG. 8 is a view illustrating the oxygen atom content rate (%), the carbon atom content rate (%), and the silicon atom content rate (%) in the gas barrier layer of the transparent conductive film 7 of Example 7.
FIG. 9 is a view illustrating the oxygen atom content rate (%), the carbon atom content rate (%), and the silicon atom content rate (%) in the gas barrier layer of the transparent conductive film 8 of Example 8.
FIG. 10 is a view illustrating the oxygen atom content rate (%), the carbon atom content rate (%), and the silicon atom content rate (%) in the gas barrier layer of the transparent conductive film 2r of Comparative Example 2.

DESCRIPTION OF EMBODIMENTS

**[0025]** [0025] A transparent conductive film, a method for producing a transparent conductive film, an electronic device member, and an electronic device according to several embodiments of the invention are described in detail in below.

1) Transparent conductive film

**[0026]** [0026] A transparent conductive film according to one embodiment of the invention includes a base layer, a gas barrier layer, and a transparent conductive layer, the gas barrier layer being formed of a material that includes at least oxygen atoms, carbon atoms, and silicon atoms, the gas barrier layer including an area (A) in which the oxygen atom content rate gradually decreases, and the carbon atom content rate gradually increases from the surface in the depth direction, the area (A) including a partial area (A1) and a partial area (A2), the partial area (A1) having an oxygen atom content rate of 20 to 55%, a carbon atom content rate of 25 to 70%, and a silicon atom content rate of 5 to 20%, based on a total content rate of oxygen atoms, carbon atoms, and silicon atoms, and the partial area (A2) having an oxygen atom content rate of 1 to 15%, a carbon atom content rate of 72 to 87%, and a silicon atom content rate of 7 to 18%, based on a total content rate of oxygen atoms, carbon atoms, and silicon atoms.

Base layer

**[0027]** [0027] The transparent conductive film according to one embodiment of the invention includes the base layer. A material for forming the base layer is not particularly limited as long as the material is suitable for the intended use of the transparent conductive film. Examples of the material for forming the base layer include synthetic resins such as polyimides, polyamides, polyamideimides, polyphenylene ethers, polyetherketones, polyether ether ketones, polyolefins, polyesters, polycarbonates, polysulfones, polyether sulfones, polyphenylene sulfides, polyallylates, acrylic resins, cycloolefin polymers, and aromatic polymers.
**[0028]** [0028] Among these, polyesters, polyamides, polysulfones, polyether sulfones, polyphenylene sulfides, polyallylates, and cycloolefin polymers are preferable due to excellent transparency and versatility. It is more preferable to use polyesters or cycloolefin polymers.
**[0029]** [0029] Examples of the polyesters include polyethylene terephthalate, polybuthylene terephthalate, polyethylene naphthalate, polyallylates, and the like.
Examples of the polyamides include wholly aromatic polyamides, nylon 6, nylon 66, nylon copolymers, and the like.
**[0030]** [0030] Examples of the cycloolefin polymers include norbornene polymers, monocyclic olefin polymers, cyclic conjugated diene polymers, vinyl alicyclic hydrocarbon polymers, and hydrogenated products thereof. Specific example of the cycloolefin polymers include APEL (ethylene-cycloolefin copolymer manufactured by Mitsui Chemicals Inc.), ARTON (norbornene polymer manufactured by JSR Corporation), ZEONOR (norbornene polymer manufactured by Zeon Corporation), and the like.
**[0031]** [0031] The thickness of the base layer is not particularly limited, and may be determined depending on the intended use of the transparent conductive film. The thickness of the base layer is normally 0.5 to 500 μm, and preferably 10 to 250 μm.

Gas barrier layer

**[0032]** [0032] The transparent conductive film according to one embodiment of the invention includes the gas barrier layer that is formed of a material that includes at least oxygen atoms, carbon atoms, and silicon atoms, the gas barrier layer including the area (A) in which the oxygen atom content rate gradually decreases, and the carbon atom content rate gradually increases from the surface in the depth direction, the area (A) including at least two partial areas having a specific oxygen atom content rate, a specific carbon atom content rate, and a specific silicon atom content rate.
**[0033]** [0033] Note that the term "surface" used herein in connection with the gas barrier layer includes the surface (upper side (surface)) of the gas barrier layer when the gas barrier layer forms the outermost surface of the transparent conductive film, and the boundary (interface) between the gas barrier layer and another layer that is stacked on the gas barrier layer.
**[0034]** [0034] The gas barrier layer may include only the area (A), or may include the area (A) as part (preferably the surface layer part) of the gas barrier layer. It is preferable that the gas barrier layer include the area (A) as part of the gas barrier layer from the viewpoint of ease of production.
The thickness of the area (A) is normally 5 to 110 nm, and preferably 10 to 50 nm.
**[0035]** [0035] The transparent conductive film according to one embodiment of the invention is configured so that the area (A) includes the partial area (A1) and the partial area (A2), the partial area (A1) having an oxygen atom content rate of 20 to 55%, a carbon atom content rate of 25 to 70%, and a silicon atom content rate of 5 to 20%, based on the total. content rate of oxygen atoms, carbon atoms, and silicon atoms, and the partial area (A2) having an oxygen atom content rate of 1 to 15%, a carbon atom content rate of 72 to 87%, and a silicon atom content rate of 7 to 18%, based on the total content rate of oxygen atoms, carbon atoms, and silicon atoms.
**[0036]** [0036] The oxygen atom content rate, the carbon atom content rate, and the silicon atom content rate are measured by the method described later in the examples.
The layer (gas barrier layer) that includes the area (A) including the partial area (A1) and the partial area (A2) exhibits an excellent gas barrier capability.
**[0037]** [0037] The partial area (A1) has the lowest carbon atom content rate and the highest oxygen atom content rate in the area (A), and has an oxygen atom content rate of 20 to 55%, a carbon atom content rate of 25 to 70%, and a silicon atom content rate of 5 to 20% based on the total content rate of oxygen atoms, carbon atoms, and silicon atoms. The partial area (A1) is normally positioned in the surface area of the gas barrier layer. The thickness of the area (A1) is normally 1 to 10 nm.
**[0038]** [0038] The partial area (A2) has an oxygen atom content rate of 1 to 15%, a carbon atom content rate of 72 to 87%, and a silicon atom content rate of 7 to 18% based on the total content rate of oxygen atoms, carbon atoms, and silicon atoms. The partial area (A2) is normally positioned adjacent to the partial area (A1) in the depth direction of the partial area (A1).
The thickness of the area (A2) is normally 5 to 100 nm.
**[0039]** [0039] The area (A) includes the partial area (A1) and the partial area (A2). The area (A) is configured so that the oxygen atom content rate gradually decreases, and the carbon atom content rate gradually increases from the surface in the depth direction.
**[0040]** [0040] The gas barrier layer included in the transparent conductive film according to one embodiment of the invention may be a polysilane compound-containing layer (hereinafter may be referred to as "polysilane compound layer") in which the area (A) is formed in its surface area. More specifically, the gas barrier layer may be a layer obtained by implanting ions into the polysilane compound-containing layer, or a layer obtained by subjecting the polysilane compound layer to a plasma treatment (described later).
**[0041]** [0041] It is preferable that the area (A) be formed in the surface layer part of the polysilane compound layer.
Note that the polysilane compound is a compound that includes at least one repeating unit selected from structural units represented by the formula (1) shown below.
**[0042]** [0042] The gas barrier layer of the transparent conductive film according to one embodiment of the invention may be a layer obtained by implanting ions into the polysilane compound layer.

Polysilane compound layer

**[0043]** [0043] The polysilane compound used in connection with the embodiments of the invention is a polymer compound that includes a repeating unit that includes an -Si-Si-bond in its molecule. Examples of the polysilane compound include a compound that includes at least one repeating unit selected from structural units represented by the following formula (1).
**[0044]** [0044]

[Chemical Formula 2]

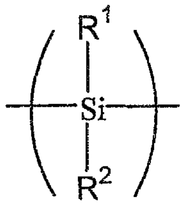

(1)

**[0045]** [0045] wherein $R^1$ and $R^2$ independently represent a hydrogen atom, an alkyl group, an alkenyl group, a cycloalky group, a cycloalkenyl group, an aryl group, a hydroxyl group, an alkoxy group, a cycloalkyloxy group, an aryloxy group, an aralkyloxy group, a substituted or unsubstituted amino group, a silyl group, or a halogen atom, provided that $R^1$ and $R^2$ may respectively be either identical or different.

**[0046]** [0046] Examples of the alkyl group represented by $R^1$ and $R^2$ include alkyl groups having 1 to 10 carbon atoms, such as a methyl group, an ethyl group, an n-propyl group, an isopropyl group, an n-butyl group, a s-butyl group, a t-butyl group, an n-pentyl group, and an n-hexyl group.

Examples of the alkenyl group include alkenyl groups having 2 to 10 carbon atoms, such as a vinyl group, an allyl group, a butenyl group, and a pentenyl group.

**[0047]** [0047] Examples of the cycloalkyl group include cycloalkyl groups having 3 to 10 carbon atoms, such as a cyclopentyl group, a cyclohexyl group, and a cyclooctyl group.

Examples of the cycloalkenyl group include cycloalkenyl groups having 4 to 10 carbon atoms, such as a cyclopentenyl group and a cyclohexenyl group.

Examples of the aryl group include aryl groups having 6 to 20 carbon atoms, such as a phenyl group, an $\alpha$-naphthyl group, and a $\beta$-naphthyl group.

**[0048]** [0048] Examples of the alkoxy group include alkoxy groups having 1 to 10 carbon atoms, such as a methoxy group, an ethoxy group, a propoxy group, an isopropoxy group, a butoxy group, a t-butoxy group, and a pentyloxy group.

Examples of the cycloalkyloxy group include cycloalkyloxy groups having 3 to 10 carbon atoms, such as a cyclopenthyloxy group and a cyclohexyloxy group.

**[0049]** [0049] Examples of the aryloxy group include aryloxy groups having 6 to 20 carbon atoms, such as a phenoxy group, a 1-naphthyloxy group, and a 2-naphthyloxy group.

Examples of the aralkyloxy group include aralkyloxy groups having 7 to 20 carbon atoms, such as a benzyloxy group, a phenethyloxy group, and a phenylpropyloxy group.

Examples of the substituted or unsubstituted amino group include an amino group; N-monosubstituted or N,N-disubstituted amino groups substituted with an alkyl group having 1 to 10 carbon atoms, a cycloalkyl group having 3 to 10 carbon atoms, an aryl group having 6 to 20 carbon atoms, an aralkyl group having 7 to 20 carbon atoms, an acyl group, or the like; and the like.

**[0050]** [0050] Examples of the silyl group include silanyl groups having 1 to 10 silicon atoms (preferably silanyl groups having 1 to 6 silicon atoms), such as a silyl group, a disilanyl group, and a trisilanyl group, substituted silyl groups (e.g., a substituted silyl group substituted with an alkyl group, a cycloalkyl group, an aryl group, an aralkyl group, an alkoxy group, or the like), and the like.

Examples of the halogen atom include a fluorine atom, a chlorine atom, a bromine atom, an iodine atom, and the like.

**[0051]** [0051] When $R^1$ and $R^2$ represent an alkyl group or an alkenyl group, the alkyl group may be substituted with a substituent, such as a substituted or unsubstituted aryl group (e.g., phenyl group or 4-methylphenyl group), an alkoxy group (e.g., methoxy group or ethoxy group), an aryloxy group (e.g., phenoxy group), a halogen atom (e.g., fluorine atom or chlorine atom), a nitro group, or a cyano group, at an arbitrary position.

**[0052]** [0052] When $R^1$ and $R^2$ represent a cycloalkyl group, a cycloalkenyl group, an aryl group, an alkoxy group, a cycloalkyloxy group, an aryloxy group, or an aralkyloxy group, the cycloalkyl group, cycloalkenyl group, aryl group, alkoxy group, cycloalkyloxy group, aryloxy group, or aralkyloxy group may be substituted with a substituent, such as an alkyl group (e.g., methyl group or ethyl group), a substituted or unsubstituted aryl group (e.g., phenyl group or 4-methylphenyl group), an alkoxy group (e.g., methoxy group or ethoxy group), an aryloxy group (e.g., phenoxy group), a halogen atom (e.g., fluorine atom or chlorine atom), a nitro group, or a cyano group, at an arbitrary position.

**[0053]** [0053] It is preferable to use a polysilane compound that includes a repeating unit represented by the formula (1) wherein $R^1$ and $R^2$ independently represent a hydrogen atom, an alkyl group having 1 to 10 carbon atoms, an aryl group having 6 to 20 carbon atoms, a hydroxyl group, an alkoxy group having 1 to 10 carbon atoms, an amino group, or a silyl group. It is more preferable to use a polysilane compound that includes a repeating unit represented by the

formula (1) wherein $R^1$ and $R^2$ independently represent a hydrogen atom, an alkyl group, or an aryl group. It is particularly preferable to use a polysilane compound that includes a repeating unit represented by the formula (1) wherein $R^1$ and $R^2$ independently represent an alkyl group having 1 to 4 carbon atoms or an aryl group having 6 to 20 carbon atoms.

**[0054]** [0054] The configuration of the polysilane compound is not particularly limited. The polysilane compound may be a homopolymer such as a noncyclic polysilane (e.g., linear polysilane, branched polysilane, or network polysilane) or a cyclic polysilane, or may be a copolymer (e.g., random copolymer, block copolymer, alternating copolymer, or comb copolymer).

When the polysilane compound is a noncyclic polysilane, the end group (end substituent) of the polysilane compound may be a hydrogen atom, a halogen atom (e.g., chlorine atom), an alkyl group, a hydroxyl group, an alkoxy group, a silyl group, or the like.

**[0055]** [0055] Specific examples of the polysilane compound include homopolymers such as a polydialkylsilane such as polydimethylsilane, poly(methylpropylsilane), poly(methylbutylsilane), poly(methylpentylsilane), poly(dibutylsilane), and poly(dihexylsilane), a polydiarylsilane such as poly(diphenylsilane), and a poly(alkylarylsilane) such as poly(methylphenylsilane); copolymers such as a copolymer of a dialkylsilane and another dialkylsilane such as a dimethylsilane-methylhexylsilane copolymer, an arylsilane-alkylarylsilane copolymer such as a phenylsilane-methylphenyisilane copolymer, and a dialkylsilane-alkylarylsilane copolymer such as a dimethylsilane-methylphenylsilane copolymer, a dimethylsilane-phenylhexylsilane copolymer, a dimethylsilane-methylnaphthylsilane copolymer, and a methylpropylsilane-methylphenylsilane copolymer; and the like.

These polysilane compounds may be used either alone or in combination.

**[0056]** [0056] The details of the polysilane compound are described in R. D. Miller, J. Michl; Chemical Review, Vol. 89, p. 1359 (1989), N. Matsumoto; Japanese Journal of Physics, Vol. 37, p. 5425 (1998), and the like. The polysilane compounds described in these documents may be used in the embodiments of the invention.

**[0057]** [0057] The weight average molecular weight of the polysilane compound is not particularly limited, but is preferably 300 to 100,000, more preferably 400 to 50,000, and still more preferably 500 to 30,000.

**[0058]** [0058] A number of polysilane compounds are known in the art, and may be produced by a known method. For example, the polysilane compound may be produced by a method that subjects a halosilane to dehalogenation/ polycondensation using magnesium as a reducing agent (magnesium reduction method, see WO98/29476, for example), a method that subjects a halosilane to dehalogenation/polycondensation in the presence of an alkali metal (Kipping method, see J. Am. Chem. Soc., 110, 124 (1988), Macromolecules, 23, 3423 (1990), for example), a method that subjects a halosilane to dehalogenation/polycondensation by electrode reduction (see J. Chem. Soc., Chem. Commun., 1161 (1990), J. Chem. Soc., Chem. Commun. 897 (1992), for example), a method that subjects a hydrosilane to dehydrogenation/condensation in the presence of a specific polymerization metal catalyst (see JP-A-4-334551, for example), a method that subjects a disilene crosslinked using a biphenyl or the like to anionic polymerization (see Macromolecules, 23, 4494 (1990), for example), a method that subjects a cyclic silane to ring-opening polymerization, or the like.

**[0059]** [0059] The polysilane compound layer may include an additional component other than the polysilane, compound as long as the object of the invention is not impaired.

Examples of the additional component include a crosslinking agent, a curing agent, an additional polymer, an aging preventive, a light stabilizer, a flame retardant, and the like.

**[0060]** [0060] The content of the polysilane compound in the polysilane compound layer is preferably 50 wt% or more, and more preferably 70 wt% or more, from the viewpoint of forming an ion-implanted layer that exhibits an excellent gas barrier capability.

**[0061]** [0061] The polysilane compound layer may be formed by an arbitrary method. For example, the polysilane compound layer may be formed by applying a layer-forming solution that includes at least one polysilane compound, an optional additional component, a solvent, and the like to the base layer or another layer, and appropriately drying the resulting film.

**[0062]** [0062] A spin coater, a knife coater, a gravure coater, or the like may be used to apply the layer-forming solution.

**[0063]** [0063] It is preferable to heat the resulting film in order to dry the film and improve the gas barrier capability of the resulting transparent conductive film. In this case, the film is heated at 80 to 150°C for several tens of seconds to several tens of minutes.

**[0064]** [0064] The thickness of the polysilane compound-containing layer is not particularly limited, but is normally 20 to 1000 nm, preferably 30 to 500 nm, and more preferably 40 to 200 nm.

According to the embodiments of the invention, a transparent conductive film that exhibits a sufficient gas barrier capability can be obtained even if the polysilane compound-containing layer has a thickness at a nanometer level.

**[0065]** [0065] Examples of the ions to be implanted include ions of a rare gas (e.g., argon, helium, neon, krypton, and xenon), a fluorocarbon, hydrogen, nitrogen, oxygen, carbon dioxide, chlorine, fluorine, sulfur, a silicon compound, and a hydrocarbon; ions of a metal (e.g., gold, silver, copper, platinum, nickel, palladium, chromium, titanium, molybdenum, niobium, tantalum, tungsten, and aluminum); and the like.

**[0066]** [0066] Among these, ions obtained by ionizing at least one gas selected from the group consisting of hydrogen,

nitrogen, oxygen, argon, helium, neon, xenon, krypton, a silicon compound, and a hydrocarbon are preferable due to ease of implantation and a capability to form an ion-implanted layer that exhibits an excellent gas barrier capability and excellent transparency.

**[0067]** [0067] Examples of the silicon compound include silane ($SiH_4$) and organosilicon compounds.
Examples of the organosilicon compounds include tetraalkoxysilanes such as tetramethoxysilane, tetraethoxysilane, tetra-n-propoxysilane, tetraisopropoxysilane, tetra-n-butoxysilane, and tetra-t-butoxysilane; substituted or unsubstituted alkylalkoxysilanes such as dimethyldimethoxysilane, dimethyldiethoxysilane, diethyldimethoxysilane, methyltriethoxysilane, ethyltrimethoxysilane, and (3,3,3-trifluoropropyl)trimethoxysilane;

**[0068]** [0068] arylalkoxysilanes such as diphenyldimethoxysilane and phenyltriethoxysilane; disiloxanes such as hexamethyldisiloxane (HMDSO); aminosilanes such as bis(dimethylamino)dimethylsilane, bis(dimethylamino)methylvinylsilane, bis(ethylamino)dimethylsilane, diethylaminotrimethylsilane, dimethylaminodimethylsilane, tetrakisdimethylaminosilane, and tris(dimethylamino)silane; silazanes such as hexamethyldisilazane, hexamethylcyclotrisilazane, heptamethyldisilazane, nonamethyltrisilazane, octamethylcyclotetrasilazane, and tetramethyldisilazane; cyanatosilanes such as tetraisocyanotasilane; halogenosilanes such as triethoxyfluorosilane; alkenylsilanes such as diallyldimethylsilane and allyltrimethylsilane; substituted or unsubstituted alkylsilanes such as di-t-butylsilane, 1,3-disilabutane, bis(trimethylsilyl) methane, trimethylsilane, tetramethylsilane, tris(trimethylsilyl)methane, tris(trimethylsilyl)silane, and benzyltrimethylsilane; silylalkynes such as bis(trimethylsilyl)acetylene, trimethylsilylacetylene, and 1-(trimethylsilyl)-1-propyne;

**[0069]** [0069] silylalkenes such as 1,4-bistrimethylsilyl-1,3-butadiyne and cyclopentadienyltrimethylsilane; arylalkylsilanes such as phenyldimethylsilane and phenyltrimethylsilane; alkynylalkylsilanes such as propargyltrimethylsilane; alkenylalkylsilanes such as vinyltrimethylsilane; disilanes such as hexamethyldisilane; siloxanes such as octamethylcyclotetrasiloxane, tetramethylcyclotetrasiloxane, and hexamethylcyclotetrasiloxane; N,O-bis(trimethylsilyl)acetamide; bis (trimethylsilyl)carbodiimide; and the like.

**[0070]** [0070] Examples of the hydrocarbon include alkanes such as methane, ethane, propane, butane, pentane, and hexane; alkenes such as ethylene, propylene, butene, and pentene; alkadienes such as pentadiene and butadiene; alkynes such as acetylene and methylacetylene; aromatic hydrocarbons such as benzene, toluene, xylene, indene, naphthalene, and phenanthrene; cycloalkanes such as cyclopropane and cyclohexane; cycloalkenes such as cyclopentene and cyclohexene; and the like.
These compounds (ions) may be used either alone or in combination.

**[0071]** [0071] The dose may be appropriately determined depending on the intended use of the transparent conductive film (e.g., gas barrier capability and transparency), and the like.

**[0072]** [0072] Ions may be implanted by applying ions (ion beams) accelerated by applying an electric field, or may be implanted by implanting ions present in plasma (plasma ion implantation method), for example. It is preferable to use the plasma ion implantation method since a transparent conductive film that exhibits an excellent gas barrier capability and the like can be easily obtained.

**[0073]** [0073] The plasma ion implantation method may be implemented by generating plasma in an atmosphere containing a plasma-generating gas, and implanting ions (cations) present in the plasma into the surface area of the ion implantation target layer by applying a negative high voltage pulse to the ion implantation target layer, for example.

**[0074]** [0074] The thickness of the ion implantation target area may be controlled by adjusting the implantation conditions (e.g., type of ions, applied voltage, and implantation time), and may be determined depending on the thickness of the ion implantation target layer, the intended use of the transparent conductive film, and the like. The thickness of the ion implantation target area is normally 10 to 1000 nm.

**[0075]** [0075] Whether or not ions have been implanted may be determined by performing elemental analysis on an area up to a depth of about 10 nm from the surface using X-ray photoelectron spectroscopy (XPS).

Transparent conductive layer

**[0076]** [0076] The transparent conductive film according to one embodiment of the invention includes the transparent conductive layer.
The gas barrier film can function as an electrode as a result of providing the transparent conductive layer. Therefore, the resulting transparent conductive film may suitably be used for an organic EL display device and the like.

**[0077]** [0077] A material for forming the transparent conductive layer is not particularly limited as long as the transparent conductive layer has a visible light transmittance at a wavelength of 550 nm of 70% or more. Examples of the material for forming the transparent conductive layer include metals such as platinum, gold, silver, and copper; carbon materials such as graphene and carbon nanotubes; organic conductive materials such as polyaniline, polyacetylene, polythiophene, polyparaphenylenevinylene, polyethylene dioxythiophene, and polypyrrole; inorganic conductive substances such as copper iodide and copper sulfide; non-oxide compounds such as chalcogenide, lanthanum hexaboride, titanium nitride, and titanium carbide; conductive metal oxides such as zinc oxide, zinc dioxide, gallium-doped zinc oxide, aluminum-doped zinc oxide, zinc oxide-doped indium oxide (IZO (registered trademark)), tin oxide, indium oxide, cadmium

oxide, tin-doped indium oxide (ITO), indium gallium zinc oxide (IGZO), fluorine-doped indium oxide, antimony-doped tin oxide, and fluorine-doped tin oxide (FTO); and the like.

**[0078]** [0078] A dopant such as iodine, arsenic pentafluoride, an alkali metal, a polyanion, or a poly(styrenesulfonate) may be added to the organic conductive material. Specific examples of the dopant include polyethylene dioxythophene ("OLEVIOS PAI 4083" manufactured by H.C. Starck-V Tech Ltd.).

**[0079]** [0079] It is preferable to use a conductive metal oxide as the material for forming the transparent conductive layer since a transparent conductive film that exhibits excellent transparency and excellent conductivity can be easily obtained. It is more preferable to use an indium-based oxide that contains indium oxide as the main component (e.g., zinc oxide-doped indium oxide (IZO (registered trademark)), indium oxide, tin-doped indium oxide (ITO), indium gallium zinc oxide (IGZO), or fluorine-doped indium oxide), a zinc-based oxide that contains zinc oxide as the main component (e.g., zinc oxide, zinc dioxide, gallium-doped zinc oxide, or aluminum-doped zinc oxide), or a tin-based oxide that contains tin oxide as the main component (e.g., tin oxide, antimony-doped tin oxide, or fluorine-doped tin oxide (FTO)). It is still more preferable to use an indium-based oxide or a zinc-based oxide. It is particularly preferable to use a zinc-based oxide.

**[0080]** [0080] It is preferable that the indium oxide content in the indium-based oxide and the zinc oxide content in the zinc-based oxide be 90 mass% or more.

**[0081]** [0081] The component other than the main component is not particularly limited. Examples of the component other than the main component include aluminum, boron, gallium, silicon, tin, germanium, antimony, iridium, rhenium, cerium, zirconium, scandium, yttrium, zinc, indium, and oxides thereof. These elements or oxides thereof are added to reduce the resistivity of the conductive layer. These elements or oxides thereof may be used either alone or in combination. The content of the component other than the main component in the transparent conductive layer is preferably 0.05 mass% to less than 10 mass% from the viewpoint of the balance between conductivity and crystallinity.

**[0082]** [0082] The transparent conductive layer may be formed by a known method. For example, the transparent conductive layer may be formed by sputtering, ion plating, vacuum deposition, chemical vapor deposition, application using a bar coater or a micro gravure coater, or the like. It is preferable to form the transparent conductive layer by sputtering since the transparent conductive layer can be easily formed.

**[0083]** [0083] A surface on which the transparent conductivematerial is to be formed may be subjected to a heat treatment under vacuum or atmospheric pressure, or may be subjected to a plasma treatment or an ultraviolet irradiation treatment before forming the transparent conductive layer.

**[0084]** [0084] The thickness of the transparent conductive layer is determined depending on the application, but is normally 10 nm to 5 μm, preferably 20 to 1000 nm, and more preferably 20 to 500 nm.

**[0085]** [0085] The resulting transparent conductive layer may optionally be patterned. The transparent conductive layer may be patterned by chemical etching (e.g., photolithography), physical etching using a laser or the like, vacuum deposition using a mask, sputtering, a lift-off method, printing, or the like.

Transparent conductive film.

**[0086]** [0086] The transparent conductive film according to one embodiment of the invention includes the base layer, the gas barrier layer, and the transparent conductive layer.
The transparent conductive film according to one embodiment of the invention may include one base layer, one gas barrier layer, and one transparent conductive layer, or may include a plurality of base layers, a plurality of gas barrier layers, and/or a plurality of transparent conductive layers, or may further include an additional layer.

**[0087]** [0087] The base layer, the gas barrier layer, and the transparent conductive layer included in the transparent conductive film according to one embodiment of the invention may be stacked in an arbitrary order.
FIG. 1 illustrates an example of the layer configuration of the conductive film according to one embodiment of the invention.

**[0088]** [0088] In FIG 1, reference sign S indicates the base layer, reference sign a indicates the gas barrier layer, and reference sign b indicates the conductive layer.
In FIG 1, (a) indicates a three-layer configuration that sequentially includes the base layer, the gas barrier layer, and the conductive layer, and (b) indicates a three-layer configuration that sequentially includes the conductive layer, the base layer, and the gas barrier layer. It is preferable that the transparent conductive film according to one embodiment of the invention have the layer configuration indicated by (a) in FIG 1 since the transparent conductive film can be easily produce.

**[0089]** [0089] Note that the gas barrier layer a may include the area (A) that includes the area (A1) and the area (A2) in its surface area, or may include only the area (A) that includes the area (A1) and the area (A2) (see (c) and (d) in FIG 1).

**[0090]** [0090] When the transparent conductive film according to one embodiment of the invention includes an additional layer, the additional layer may be a single layer, or may include a plurality of identical or different layers. The additional layer may be situated (stacked) at an arbitrary position. The position of the additional layer may be determined depending on the function and the like of the additional layer.
Examples of the additional layer include a hard coat layer, an inorganic compound layer, an impact-absorbing layer, a primer layer, and the like.

**[0091]** [0091] The hard coat layer is provided to prevent a situation in which the surface of the transparent conductive film is damaged. A material for forming the hard coat layer is not particularly limited. Examples of the material for forming the hard coat layer include energy ray-curable resins, heat-curable resins, and the like.
The thickness of the hard coat layer is normally 0.1 to 20 $\mu$m, and preferably 1 to 10 $\mu$m.
**[0092]** [0092] The inorganic compound layer is provided in order to improve the gas barrier capability. The inorganic compound layer is formed of one or more inorganic compounds. Examples of the inorganic compounds include inorganic compounds that can be deposited under vacuum, and exhibit a gas barrier capability, such as inorganic oxides, inorganic nitrides, inorganic carbides, inorganic sulfides, and composites thereof (e.g., inorganic oxynitride, inorganic oxycarbide, inorganic carbonitride, and inorganic oxycarbonitride).
**[0093]** [0093] The thickness of the inorganic compound layer is normally 10 to 1000 nm, preferably 20 to 500 nm, and more preferably 20 to 100 nm.
**[0094]** [0094] The impact-absorbing layer protects the gas barrier layer when an impact is applied to the gas barrier layer. A material for forming the impact-absorbing layer is not particularly limited. Examples of the material for forming the impact-absorbing layer include acrylic resins, urethane resins, silicone resins, olefin resins, rubber materials, and the like.
A product commercially available as a pressure-sensitive adhesive, a coating material, a sealing material, or the like may also be used as the material for forming the impact-absorbing layer. It is preferable to use a pressure-sensitive adhesive (e.g., acrylic pressure-sensitive adhesive, silicone pressure-sensitive adhesive, or rubber pressure-sensitive adhesive).
**[0095]** [0095] The impact-absorbing layer may be formed by an arbitrary method. For example, the impact-absorbing layer may be formed by applying a solution that includes the material (e.g., pressure-sensitive adhesive) for forming the impact-absorbing layer and an optional component (e.g., solvent) to the layer on which the impact-absorbing layer is to be formed, drying the resulting film, and optionally heating the dried film.
Alternatively, the impact-absorbing layer may be formed on a release base, and transferred to the layer on which the impact-absorbing layer is to be formed.
The thickness of the impact-absorbing layer is normally 1 to 100 $\mu$m, and preferably 5 to 50 $\mu$m.
**[0096]** [0096] The primer layer improves interlayer adhesion between the base layer and the gas barrier layer or the transparent conductive layer. A transparent conductive film that exhibits excellent interlayer adhesion and excellent surface flatness (i.e., the surface of the base can be planarized) can be obtained by providing the primer layer.
**[0097]** [0097] An arbitrary known material may be used to form the primer layer. Examples of the material that may be used to form the primer layer include silicon-containing compounds; a photopolymerizable composition that includes a photopolymerizable compound formed of a photopolymerizable monomer and/or a photopolymerizable prepolymer, and an initiator that generates radicals at least due to visible light or UV rays; resins such as a polyester resin, a polyurethane resin (particularly a two-component curable resin that includes an isocyanate compound and a polyacryl polyol, a polyester polyol, a polyether polyol, or the like), an acrylic resin, a polycarbonate resin, a vinyl chloride/vinyl acetate copolymer, a polyvinyl butyral resin, and a nitrocellulose resin; alkyl titanates; ethyleneimine; and the like. These materials may be used either alone or in combination.
**[0098]** [0098] The primer layer may be formed by dissolving or dispersing the material for forming the primer layer in an appropriate solvent to prepare a primer layer-forming solution, applying the primer layer-forming solution to one side or each side of the base layer, drying the resulting film, and optionally heating the dried film.
**[0099]** [0099] The primer layer-forming solution may be applied to the base layer by a normal wet coating method. Examples of the wet coating method include dipping, roll coating, gravure coating, knife coating, air knife coating, roll knife coating, die coating, screen printing, spray coating, a gravure offset method, and the like.
**[0100]** [0100] The film formed by applying the primer layer-forming solution may be dried by hot-air drying, heat roll drying, infrared irradiation, or the like. The thickness of the primer layer is normally 10 to 1000 nm.
**[0101]** [0101] Ions may be implanted into the primer layer in the same manner as in the case of forming an ion-implanted layer (described later). A transparent conductive film that exhibits a more excellent gas barrier capability can be obtained by implanting ions into the primer layer.
**[0102]** [0102] The thickness of the transparent conductive film according to one embodiment of the invention is not particularly limited, and may be appropriately determined depending on the application of the resulting electronic device and the like. The thickness of the transparent conductive film is normally 1 to 1000 $\mu$m.
**[0103]** [0103] The transparent conductive film according to one embodiment of the invention exhibits an excellent gas barrier capability and excellent transparency, and has low sheet resistance (i.e., exhibits excellent conductivity) even under a high-temperature/high-humidity environment.
**[0104]** [0104] The transparent conductive film according to one embodiment of the invention exhibits an excellent gas barrier capability since the transparent conductive film has a low gas (e.g., water vapor) transmission rate. For example, the water vapor transmission rate of the transparent conductive film at a temperature of 40°C and a relative humidity of 90% is normally 0.5 g/m$^2$/day or less, preferably less than 0.5 g/m$^2$/day or less, and more preferably 0.35 g/m$^2$/day or

less. The gas (e.g., water vapor) transmission rate of the transparent conductive film may be measured using a known gas transmission rate measurement system.

**[0105]** [0105] The transparent conductive film according to one embodiment of the invention exhibits excellent transparency since the transparent conductive film has high visible light transmittance. The visible light transmittance (wavelength: 550 nm) of the transparent conductive film according to one embodiment of the invention is normally 70% or more. The visible light transmittance of the transparent conductive film may be measured using a known visible light transmittance measurement system.

**[0106]** [0106] The transparent conductive film according to one embodiment of the invention exhibits excellent conductivity since the transparent conductive film has low sheet resistance (surface resistivity). The sheet resistance (surface resistivity) of the transparent conductive film according to one embodiment of the invention is normally 1000 Ω/square or less, and preferably 600 Ω/squire or less. The sheet resistance of the transparent conductive film may be measured by a known method.

**[0107]** [0107] The transparent conductive film according to one embodiment of the invention has low sheet resistance (i.e., exhibits excellent conductivity) even under a high-temperature/high-humidity environment since the transparent conductive film has small sheet resistance change rates T1 and T2 (see below), for example.

**[0108]** [0108]

[Expression 1]

$$T1 = (R1 - R0) / R0$$
$$T2 = (R2 - R0) / R0$$

**[0109]** [0109] where, R0 is the initial sheet resistance of the transparent conductive film, R1 is the sheet resistance of the transparent conductive film after the transparent conductive film has been allowed to stand at 60°C for 3 days, and R2 is the sheet resistance of the transparent conductive film after the transparent conductive film has been allowed to stand at 60°C and 90%RH for 3 days.

**[0110]** [0110] The sheet resistance change rate T1 of the transparent conductive film according to one embodiment of the invention is normally less than 1.0, preferably 0.5 or less, and more preferably 0.05 or less, and the sheet resistance change rate T2 of the transparent conductive film according to one embodiment of the invention is normally 1.0 or less, preferably 0.5 or less, and more preferably 0.15 or less.

2) Method for producing transparent conductive film

**[0111]** [0111] A method for producing a transparent conductive film according to one embodiment of the invention includes implanting ions into a polysilane compound layer of a formed body that includes the polysilane compound layer in its surface area.

The method for producing a transparent conductive film according to one embodiment of the invention can easily and efficiently produce the transparent conductive film according to one embodiment of the invention.

**[0112]** [0112] The ions mentioned above in connection with the transparent conductive film (see "1) Transparent conductive film") are preferable as the ions used for the method for producing a transparent conductive film according to one embodiment of the invention. It is preferable to implant the ions by a plasma ion implantation method.

**[0113]** [0113] The plasma ion implantation method includes applying a negative high-voltage pulse to a formed body that includes a surface polymer layer and is exposed to plasma, to implant ions present in the plasma into the surface area of the polymer layer.

**[0114]** [0114] It is preferable to use (A) a plasma ion implantation method that implants ions present in plasma generated by utilizing an external electric field into the surface area of the polysilane compound layer, or (B) a plasma ion implantation method that implants ions present in plasma generated due to an electric field produced by applying a negative high-voltage pulse to the polysilane compound layer into the surface area of the polysilane compound layer.

**[0115]** [0115] When using the method (A), it is preferable to set the ion implantation pressure (plasma ion implantation pressure) to 0.01 to 1 Pa. When the plasma ion implantation pressure is within the above range, a uniform ion-implanted layer can be easily and efficiently formed. This makes it possible to efficiently form an ion-implanted layer that exhibits transparency and a gas barrier capability in combination.

**[0116]** [0116] The method (B) does not require increasing the degree of decompression, allows a simple operation, and significantly reduces the processing time. Moreover, the entire silicate layer can be uniformly processed, and ions present in the plasma can be continuously implanted into the surface area of the polysilane compound layer with high energy by applying a negative high voltage pulse. The method (B) also has an advantage in that ions can be uniformly implanted into the surface area of the polysilane compound layer by merely applying a negative high-voltage pulse to the polysilane compound layer without requiring a special means such as a high-frequency power supply (e.g., radio

frequency (RF) power supply or microwave power supply).

**[0117]** [0117] When using the method (A) or (B), the pulse width when applying a negative high-voltage pulse (i.e., during ion implantation) is preferably 1 to 15 μs. If the pulse width is within the above range, uniform ion implantation can be performed more easily and efficiently.

**[0118]** [0118] The voltage applied when generating plasma is preferably -1 to -50 kV, more preferably -1 to -30 kV, and particularly preferably -5 to -20 kV. If the applied voltage is higher than -1 kV, the dose may be insufficient, and the desired performance may not be obtained. If the applied voltage is lower than -50 kV, the transparent conductive film may be electrically charged during ion implantation, or the transparent conductive film may be colored, for example.

**[0119]** [0119] The ion species used for plasma ion implantation is the same as described above. It is preferable to use ions of hydrogen, nitrogen, oxygen, argon, helium, neon, xenon, or krypton due to ease of ion implantation and a. capability to form a transparent conductive film that exhibits excellent transparency and an excellent gas barrier capability. It is more preferable to use ions of nitrogen, oxygen, argon, or helium.

A plasma ion implantation apparatus is used when implanting ions present in plasma into the surface area of the polysilane compound layer.

Specific examples of the plasma ion implantation apparatus include (α) a system that causes a polymer layer (hereinafter may be referred to as "ion implantation target layer") to be evenly enclosed by plasma by superimposing high-frequency electric power on a feed-through that applies a negative high-voltage pulse to the ion implantation target layer so that ions present in the plasma are attracted to and collide with the target, and thereby implanted and deposited therein (JP-A-2001-26887), (β) a system that includes an antenna in a chamber, wherein high-frequency electric power is applied to generate plasma, and positive and negative pulses are alternately applied to the ion implantation target layer after the plasma has reached an area around the ion implantation target layer, so that ions present in the plasma are attracted to and implanted into the target while heating the ion implantation target layer, causing electrons present in the plasma to be attracted to and collide with the target due to the positive pulse, and applying the negative pulse while controlling the temperature by controlling the pulse factor (JP-A-2001-156013), (γ) a plasma ion implantation apparatus that generates plasma using an external electric field utilizing a high-frequency electric power supply such as a microwave power supply, and causes ions present in the plasma to be attracted to and implanted into the target by applying a high-voltage pulse, (δ) a plasma ion implantation apparatus that implants ions present in plasma generated due to an electric field produced by applying a high-voltage pulse without using an external electric field, and the like.

**[0120]** [0120] It is preferable to use the plasma ion implantation apparatus (γ) or (δ) since the plasma ion implantation apparatus (γ) or (δ) allows a simple operation, significantly reduces the processing time, and can be continuously used. The method disclosed in WO2010/021326 may be used when using the plasma ion implantation apparatus (γ) or (δ).

**[0121]** [0121] Since the plasma ion implantation apparatus (γ) or (δ) is configured so that the high-voltage pulse power supply also serves as the plasma generation means that generates plasma, it is possible to generate plasma and implant ions into the surface area of the polysilane compound layer by merely applying a negative high-voltage pulse to the polysilane compound layer without requiring a special means such as a high-frequency power supply (e.g., RF power supply or microwave power supply), and continuously form a plasma-implanted layer to mass-produce a transparent conductive film in which the plasma-implanted layer is formed.

**[0122]** [0122] It is preferable to implant ions into the surface area of the polysilane compound layer while feeding a long formed body that includes a surface polysilane compound layer in a given direction. According to this method, ions can be implanted into a long formed body wound around a feed-out roll while feeding the formed body in a given direction, which can then be wound around a wind-up roll, for example. Therefore, ion implantation can be continuously performed.

**[0123]** [0123] The long formed body may include only the base layer and the silicate layer, or may include an additional layer as long as the polysilane compound layer is formed in its surface area.

The thickness of the formed body is preferably 1 to 500 μm, and more preferably 5 to 300 μm, from the viewpoint of winding/unwinding operability and feeding operability.

**[0124]** [0124] The transparent conductive film according to one embodiment of the invention in which the base layer, the gas barrier layer, and the transparent conductive layer are sequentially stacked, may be produced as described below.

**[0125]** [0125] A polysilane compound layer is formed on one side of a long base (base layer). The polysilane compound layer may be formed by applying the polysilane compound layer-forming solution to one side of the long base using a coater while feeding the long base in a given direction, drying the resulting film, and optionally heating the dried film, for example.

**[0126]** [0126] The polysilane compound layer is then subjected to plasma ion implantation using a plasma ion implantation apparatus to obtain a long formed body in which a gas barrier layer is formed on a base layer.

**[0127]** [0127] A transparent conductive layer is formed on the gas barrier layer of the long formed body by sputtering.

**[0128]** [0128] The transparent conductive film according to one embodiment of the invention can thus be obtained.

The transparent conductive film according to one embodiment of the invention can be easily produced by the above method for producing a transparent conductive film according to one embodiment of the invention.

3) Electronic device member and electronic device

**[0129]** [0129] An electronic device member according to one embodiment of the invention includes the transparent conductive film according to one embodiment of the invention. Therefore, the electronic device member according to one embodiment of the invention exhibits an excellent gas barrier capability, and prevents a deterioration in an element (member or device) due to gas (e.g., water vapor). Since the electronic device member exhibits high transparency, and has low sheet resistance (shows a small change in sheet resistance) (i.e., exhibits excellent conductivity) even under a high-temperature/high-humidity environment, the electronic device member may suitably be used as a display member for liquid crystal displays, EL displays, and the like.

**[0130]** [0130] An electronic device according to one embodiment of the invention includes the electronic device member according to one embodiment of the invention. Specific examples of the electronic device include a liquid crystal display, an organic EL display, an inorganic EL display, electronic paper, a solar cell, and the like.
Since the electronic device according to one embodiment of the invention includes the electronic device member that includes the transparent conductive film according to one embodiment of the invention, the electronic device exhibits an excellent gas barrier capability, excellent transparency, and excellent conductivity.

EXAMPLES

**[0131]** [0131] The invention is further described below by way of examples. Note that the invention is not limited to the following examples.

**[0132]** [0132] The following plasma ion implantation apparatus, water vapor transmission rate measurement system, visible light transmittance measurement system, sheet resistance measurement system, and XPS elemental analysis system of surface layer part of gas barrier layer were used, and water vapor transmission rate measurement conditions, visible light transmittance measurement conditions, humidity and heat test method were adopted in the examples.

**[0133]** [0133] Plasma ion implantation apparatus
RF power supply: "RF56000" manufactured by JEOL Ltd.
High-voltage pulse power supply: "PV-3-HSHV-0835" manufactured by Kurita Seisakusho Co., Ltd.

Water vapor transmission rate measurement system and conditions

**[0134]** [0134] The water vapor transmission rate of the transparent conductive film was measured at a temperature of 40°C and a relative humidity of 90% using the following measurement system (measured before and after the bending test).
The water vapor transmission rate was measured using a water vapor transmission rate measurement system "L89-5000" (manufactured by LYSSY) (when the water vapor transmission rate was 0.01 $g/m^2/day$ or more), or "deltaperm" (manufactured by TECHNOLOX) (when the water vapor transmission rate was less than 0.01 $g/m^2/day$).

**[0135]** [0135] The bending test was performed by the following method.
The transparent conductive film was folded at the center so that the surface of the transparent conductive layer was positioned outside. The transparent conductive film was passed between two rolls of a laminator ("LAMIPACKER LPC1502" manufactured by Fujipla, Inc.) at a laminating speed of 5 m/min and a temperature of 23°C. The bending test was performed in a state in which a pasteboard (thickness: 1 mm) was provided on the inner side of the transparent conductive film.

Visible light transmittance measurement system and conditions

**[0136]** [0136] The visible light transmittance was measured at a wavelength of 550 nm using the following measurement system.
Visible light transmittance measurement system: "UV-3101PC" manufactured by Shimadzu Corporation

Sheet resistance measurement system

**[0137]** [0137] The sheet resistance of the transparent conductive film was determined by measuring the surface resistivity of the transparent conductive layer at a temperature of 23°C and a relative humidity of 50% using the following measurement system. A probe "PROBE TYPE LSP" (manufactured by Mitsubishi Chemical Analytech Co., Ltd.) was used for the measurement.
Sheet resistance measurement system: "LORESTA-GP MCP-T600" manufactured by Mitsubishi Chemical Corporation

Humidity and heat test method

**[0138]** [0138] The transparent conductive film was allowed to stand at 60°C or at 60°C and 90%RH for 3 days. After conditioning the transparent conductive film at 23°C and 50%RH for 1 day, the sheet resistance of the transparent conductive film was measured.
The sheet resistance change rates T1 and T2 were calculated by the following expression.
Note that R0 is the initial sheet resistance of the transparent conductive film, R1 is the sheet resistance of the transparent conductive film after the transparent conductive film had been allowed to stand at 60°C for 3 days, and R2 is the sheet resistance of the transparent conductive film after the transparent conductive film had been allowed to stand at 60°C and 90%RH for 3 days. The sign "RH" indicates relative humidity.
**[0139]** [0139]

[Expression 2]

$$T1 = (R1 - R0) / R0$$
$$T2 = (R2 - R0) / R0$$

XPS elemental analysis system of gas barrier layer

**[0140]** [0140] The transparent conductive layer of the transparent conductive film was removed by sputtering to expose the interface of the gas barrier layer with the transparent conductive layer, and the oxygen atom content rate, the carbon atom content rate, and the silicon atom content rate were measured using the following measurement system under the following measurement conditions.
**[0141]** [0141] X-ray photoelectron spectrometer: "PHI Quantera SXM" manufactured by ULVAC-PHI, Incorporated
X-ray beam diameter: 100 μm
Electric power: 25 W
Voltage: 15 kV
Take-off angle: 45°
Sputtering conditions
Sputtering gas: argon
Applied voltage: -4 kV

Example 1

**[0142]** [0142] A solution prepared by dissolving a polysilane compound including a repeating unit represented by the formula (1) wherein $R^1=C_6H_5$ and $R^2=CL_3$ ("OGSOL, SI10" manufactured by Osaka Gas Chemicals Co. Ltd., Mw=22,100) (polysilane compound) in a toluene/ethyl methyl ketone mixed solvent (toluene:ethyl methyl ketone=7:3, concentration: 5 wt%) (hereinafter referred to as "polysilane compound layer-forming solution A") was applied to a polyethylene terephthalate film ("PET188 A-4300" manufactured by Toyobo Co., Ltd., thickness: 188 μm, hereinafter referred to as "PET film") (base layer), and heated at 120°C for 1 minute to form a polysilane compound layer (thickness: 100 nm) on the PET film. A formed body was thus obtained. Ions were implanted into the surface of the polysilane compound layer using argon (Ar) as a plasma-generating gas by utilizing a plasma ion implantation apparatus.
**[0143]** [0143] Plasma ion implantation conditions
Gas flow rate: 100 sccm
Duty ratio: 1.0%
Repetition frequency: 1000 Hz
Applied voltage: -15 kV
RF power supply: frequency: 13.56 MHz, applied electric power: 1000 W
Chamber internal pressure: 0.2 Pa
Pulse width: 5 μs
Processing time (ion implantation time): 5 min
Line (feed) speed: 0.2 m/min
**[0144]** [0144] A transparent conductive layer (thickness: 100 nm) was formed on the ion-implanted side of the formed body by DC magnetron sputtering using a zinc oxide target material containing 5.7 mass% of $Ga_2O_3$ (manufactured by Sumitomo Metal Mining Co., Ltd.) to obtain a transparent conductive film 1.
**[0145]** [0145] The sputtering conditions are shown below.
Substrate temperature: room temperature

DC output: 500 W
Carrier gas: argon and oxygen (flow rate ratio: 100:1)
Degree of vacuum: 0.3 to 0.8 Pa

Example 2

**[0146]** [0146] A transparent conductive film 2 was obtained in the same manner as in Example 1, except that helium (He) was used as the plasma-generating gas instead of argon.

Example 3

**[0147]** [0147] A transparent conductive film 3 was obtained in the same manner as in Example 1, except that nitrogen ($N_2$) was used as the plasma-generating gas instead of argon.

Example 4

**[0148]** [0148] A transparent conductive film 4 was obtained in the same manner as in Example 1, except that oxygen ($O_2$) was used as the plasma-generating gas instead of argon.

Example 5

**[0149]** [0149] A transparent conductive film 5 was obtained in the same manner as in Example 1, except that krypton (Kr) was used as the plasma-generating gas instead of argon.

Example 6

**[0150]** [0150] A transparent conductive film 6 was obtained in the same manner as in Example 1, except that the applied voltage was changed to -15 kV.

Example 7

**[0151]** [0151] A transparent conductive film 7 was obtained in the same manner as in Example 1, except that the applied voltage was changed to -20 kV.

Example 8

**[0152]** [0152] A transparent conductive film 8 was obtained in the same manner as in Example 1, except that a mixture of a polysilane compound mainly containing a polyphenylsilane skeleton and a polyalkylsilane skeleton (Mw=1300) and an epoxy resin (crosslinking agent) ("OGSOL SI-20-12" manufactured by Osaka Gas Chemicals Co. Ltd.) (hereinafter referred to as "polysilane compound layer-forming solution B") was used instead of the polysilane compound layer-forming solution A.

Comparative Example 1

**[0153]** [0153] A transparent conductive layer was formed directly on the PET film in the same manner as in Example 1 to obtain a transparent conductive film 1r.

Comparative Example 2

**[0154]** [0154] A transparent conductive film 2r was obtained in the same manner as in Example 1, except that plasma ion implantation was not performed.

Comparative Example 3

**[0155]** [0155] A transparent conductive film 3r was obtained in the same manner as in Example 1, except that ions were implanted into the PET film in the same manner as in Example 1, and a transparent conductive layer was formed on the PET film in the same manner as in Example 1.

Comparative Example 4

**[0156]** [0156] A silicon nitride (SiN) film (thickness: 50 nm) was formed on the PET film by sputtering, and a transparent conductive layer was formed on the silicon nitride (SiN) film in the same manner as in Example 1 to obtain a transparent conductive film 4r.

Comparative Example 5

**[0157]** [0157] A transparent conductive film 5r was obtained in the same manner as in Example 1, except that a urethane acrylate layer (thickness: 1 μm) ("URETHANE ACRYLATE 575BC" manufactured by Arakawa Chemical Industries, Ltd.) was formed instead of the polysilane compound layer.

**[0158]** [0158] The type of the polysilane compound layer-forming solution, the ion implantation gas (plasma-generating gas), and the applied voltage during ion implantation used in Examples 1 to 8 and Comparative Examples 1 to 5 are shown in Table 1.

**[0159]** [0159] The transparent conductive films obtained in Examples 1 to 8 and Comparative Example 2 were subjected to elemental analysis using an X-ray photoelectron spectroscopy (XPS) system to analyze the oxygen atom content rate, the carbon atom content rate, and the silicon atom content rate in the depth direction from the surface of the gas barrier layer. The gas barrier layer was subjected to sputtering using argon gas, and the oxygen atom content rate, the carbon atom content rate, and the silicon atom content rate in the surface exposed by sputtering were measured. This operation was repeated to determine the oxygen atom content rate, the carbon atom content rate, and the silicon atom content rate in the depth direction. The results are shown in FIGS. 2 to 10.
The values measured on the surface (partial area (A1)) of the ion-implanted side of the gas barrier layer (the surface of the polysilane compound layer in Comparative Example 2) are shown in Table 1.

**[0160]** [0160] In FIGS. 2 to 10, the vertical axis indicates the oxygen atom content rate (%), the carbon atom content rate (%), and the silicon atom content rate (%) based on the total content rate (=100%) of oxygen atoms, carbon atoms, and silicon atoms, and the horizontal axis indicates the cumulative sputtering time (min). Since the sputtering rate was constant, the cumulative sputtering time corresponds to the depth. In FIGS. 2 to 10, a square mark (C1s) indicates the carbon atom content rate, a round mark (Ols) indicates the oxygen atom content rate, and a triangular mark (Si2p) indicates the silicon atom content rate.

**[0161]** [0161] As shown in Table 1 and FIGS. 2 to 10, it was confirmed that the transparent conductive films 1 to 8 obtained in Examples 1 to 8 had a configuration in which the gas barrier layer was formed of a material that includes at least oxygen atoms, carbon atoms, and silicon atoms, the gas barrier layer including an area (A) in which the oxygen atom content rate gradually decreases, and the carbon atom content rate gradually increases from the surface in the depth direction, the area (A) including a partial area (A1) and a partial area (A2), the partial area (A1) having an oxygen atom content rate of 20 to 55%, a carbon atom content rate of 25 to 70%, and a silicon atom content rate of 5 to 20%, based on a total content rate of oxygen atoms, carbon atoms, and silicon atoms, and the partial area (A2) having an oxygen atom content rate of 1 to 15%, a carbon atom content rate of 72 to 87%, and a silicon atom content rate of 7 to 18%, based on the total content rate of oxygen atoms, carbon atoms, and silicon atoms.
On the other hand, the gas barrier layer of the transparent conductive film 2r obtained in Comparative Example 2 did not include the area (A).

**[0162]** [0160]

TABLE 1

| | Polysilane layer-forming solution | Plasma-generating g gas | Applied voltage (kV) | Contend rate in surface (partial area (A1)) of ion-implanted side of gas barrier layer (%) | | |
|---|---|---|---|---|---|---|
| | | | | Carbon atom | Oxygen atom | Silicon atom |
| Example 1 | A | Ar | -10 | 67.6 | 24.1 | 8.3 |
| Example 2 | A | He | -10 | 58.9 | 30.8 | 10.3 |
| Example 3 | A | $N_2$ | -10 | 38.9 | 45.3 | 15.8 |
| Example 4 | A | $O_2$ | -10 | 28.8 | 52.9 | 18.3 |
| Example 5 | A | Kr | -10 | 62.5 | 26.8 | 10.7 |
| Example 6 | A | Ar | -15 | 58.8 | 30.6 | 10.6 |
| Example 7 | A | Ar | -20 | 57.1 | 31.6 | 11.2 |

(continued)

| | Polysilane layer-forming solution | Plasma-generating g gas | Applied voltage (kV) | Contend rate in surface (partial area (A1)) of ion-implanted side of gas barrier layer (%) | | |
|---|---|---|---|---|---|---|
| | | | | Carbon atom | Oxygen atom | Silicon atom |
| Example 8 | B | Ar | -10 | 56.8 | 31.4 | 11.8 |
| Comparative Example 1 | - | - | - | - | - | - |
| Comparative Example 2 | A | - | - | 86.5 | 2.4 | 11.1 |
| Comparative Example 3 | - | Ar | -10 | | | |
| Comparative Example 4 | | - | - | 0 | 64.8 | 35.2 |
| Comparative Example 5 | - | Ar | -10 | | | |

**[0163]** [0161] The water vapor transmission rate, the visible light transmittance (wavelength: 550 nm), and the sheet resistance (R0) of the transparent conductive films 1 to 8 obtained in Examples 1 to 8 and the transparent conductive films 1r to 5r obtained in Comparative Examples 1 to 5 were measured. The measurement results are shown in Table 2. After subjecting the transparent conductive films to the humidity and heat test, the sheet resistances R1 and R2 were measured, and the sheet resistance change rates T1 and T2 were calculated. The results are shown in Table 2.

**[0164]** [0162]

TABLE2

| | Transparent conductive film | Water vapor transmission rate ($g/m^2/day$) | | Visible light transmittance (%) | Sheet resistance (Ω/ square) | | | T1 | T2 |
|---|---|---|---|---|---|---|---|---|---|
| | | Before bending test | After bending test | | Initial value (R0) | 60°C (after 3 days) (R1) | 60°C, 90%RH (after 3 days) (R2) | | |
| Example 1 | 1 | 0.20 | 0.62 | 80 | 510 | 515 | 530 | 0.01 | 0.04 |
| Example 2 | 2 | 0.15 | 0.55 | 79 | 500 | 510 | 520 | 0.02 | 0.04 |
| Example 3 | 3 | 0.24 | 0.58 | 80 | 520 | 525 | 580 | 0.01 | 0.12 |
| Example 4 | 4 | 0.18 | 0.44 | 80 | 515 | 520 | 580 | 0.01 | 0.13 |
| Example 5 | 5 | 0.20 | 0.52 | 81 | 520 | 530 | 550 | 0.02 | 0.06 |
| Example 6 | 6 | 0.13 | 0.34 | 79 | 500 | 515 | 540 | 0.03 | 0.08 |
| Example 7 | 7 | 0.12 | 0.30 | 78 | 515 | 515 | 550 | 0.00 | 0.07 |
| Example 8 | 8 | 0.15 | 0.20 | 80 | 520 | 525 | 570 | 0.01 | 0.10 |
| Comparative Example 1 | 1r | 13.7 | 14.0 | 91 | 520 | 2500 | 38000 | 3.81 | 72.08 |
| Comparative Example 2 | 2r | 13.5 | 13.5 | 91 | 500 | 3200 | 35000 | 5.40 | 69.00 |
| Comparative Example 3 | 3r | 7.98 | 9.37 | 67 | 515 | 1900 | 20000 | 2.69 | 37.83 |

(continued)

| | Transparent conductive film | Water vapor transmission rate ($g/m^2/day$) | | Visible light transmittance (%) | Sheet resistance (Ω/square) | | | T1 | T2 |
|---|---|---|---|---|---|---|---|---|---|
| | | Before bending test | After bending test | | Initial value (R0) | 60°C (after 3 days) (R1) | 60°C, 90%RH (after 3 days) (R2) | | |
| Comparative Example 4 | 4r | 0.55 | 1.21 | 71 | 510 | 520 | 600 | 0.02 | 0.18 |
| Comparative Example 5 | 5r | 10.0 | 13.3 | 67 | 515 | 2500 | 22000 | 3.85 | 41.72 |

**[0165]** [0163] As shown in Table 2, the transparent conductive films 1 to 8 obtained in Examples 1 to 8 had a low water vapor transmission rate (i.e., exhibited an excellent gas barrier capability) before and after the bending test. The transparent conductive films 1 to 8 had high visible light transmittance (i.e., 70% or more) and low sheet resistance (i.e., exhibited excellent transparency and conductivity).
The transparent conductive films 1 to 8 subjected to the humidity and heat test had small sheet resistance change rates T1 and T2 (0.03 or less and 0.13 or less, respectively). Therefore, it was confirmed that an increase in sheet resistance could be suppressed even under a high-temperature/high-humidity environment.

REFERENCE SIGNS LIST

**[0166]** [0164]

a Gas barrier layer
b Conductive layer
S Base layer

## Claims

1. A transparent conductive film comprising a base layer, a gas barrier layer, and a transparent conductive layer,
the gas barrier layer being formed of a material that includes at least oxygen atoms, carbon atoms, and silicon atoms, the gas barrier layer including an area (A) in which an oxygen atom content rate gradually decreases, and a carbon atom content rate gradually increases from a surface in a depth direction,
the area (A) including a partial area (A1) and a partial area (A2), the partial area (A1) having an oxygen atom content rate of 20 to 55%, a carbon atom content rate of 25 to 70%, and a silicon atom content rate of 5 to 20%, based on a total content rate of oxygen atoms, carbon atoms, and silicon atoms, and the partial area (A2) having an oxygen atom content rate of 1 to 15%, a carbon atom content rate of 72 to 87%, and a silicon atom content rate of 7 to 18%, based on a total content rate of oxygen atoms, carbon atoms, and silicon atoms.

2. The transparent conductive film according to claim 1, wherein the area (A) is formed in a surface layer part of a polysilane compound-containing layer.

3. A transparent conductive film comprising a base layer, a gas barrier layer, and a transparent conductive layer, the gas barrier layer including an ion-implanted layer obtained by implanting ions into a polysilane compound-containing layer.

4. The transparent conductive film according to claim 2 or 3, wherein the polysilane compound includes a repeating unit represented by a formula (1),

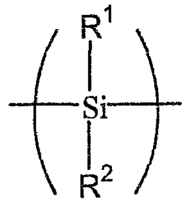

(1)

wherein $R^1$ and $R^2$ independently represent a hydrogen atom, an alkyl group, an alkenyl group, a cycloalkyl group, a cycloalkenyl group, an aryl group, a hydroxyl group, an alkoxy group, a cycloalkyloxy group, an aryloxy group, an aralkyloxy group, a substituted or unsubstituted amino group, a silyl group, or a halogen atom, provided that $R^1$ and $R^2$ may respectively be either identical or different.

**5.** The transparent conductive film according to claim 3, wherein the gas barrier layer is a layer obtained by implanting ions into the polysilane compound-containing layer by a plasma ion implantation method.

**6.** The transparent conductive film according to claim 3, wherein the ions are obtained by ionizing at least one gas selected from a group consisting of hydrogen, nitrogen, oxygen, argon, helium, neon, xenon, krypton, a silicon compound, and a hydrocarbon.

**7.** The transparent conductive film according to claim 1 or 3, wherein the transparent conductive layer is formed of a conductive metal oxide.

**8.** The transparent conductive film according to claim 7, wherein the conductive metal oxide is a zinc-based oxide.

**9.** The transparent conductive filmsaccording to claim 1 or 3, the transparent conductive film having a water vapor transmission rate at a temperature of 40°C and a relative humidity of 90% of less than 0.5 $g/m^2$/day.

**10.** A method for producing the transparent conductive film according to any one of claims 2 to 9, the method comprising implanting ions into a polysilane compound-containing layer of a formed body that includes the polysilane compound-containing layer in its surface area.

**11.** The method according to claim 10, wherein the ions are obtained by ionizing at least one gas selected from a group consisting of hydrogen, oxygen, nitrogen, argon, helium, xenon, krypton, a silicon compound, and a hydrocarbon.

**12.** The method according to claim 10, wherein the ions are implanted by a plasma ion implantation method.

**13.** An electronic device member comprising the transparent conductive film according to any one of claims 1 to 9.

**14.** An electronic device comprising the electronic device member according to claim 13.

FIG.1

(a)

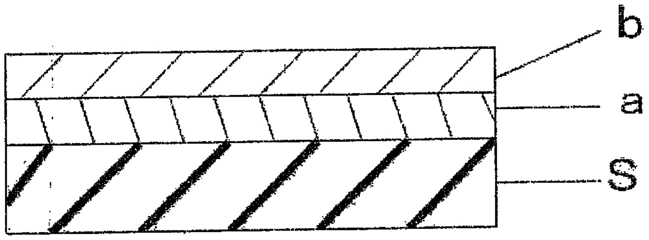


(b)

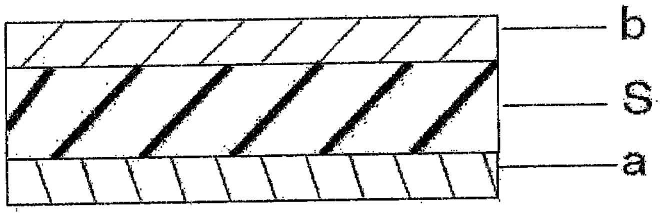


(c)

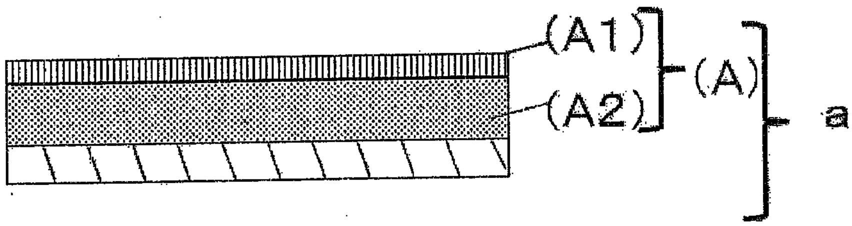


(d)

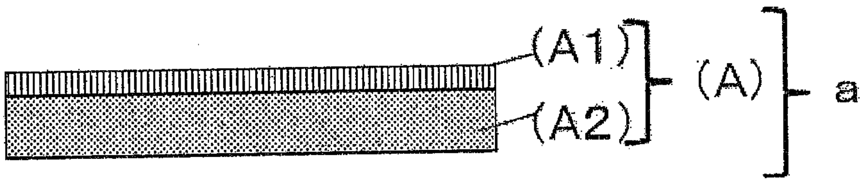

FIG.2

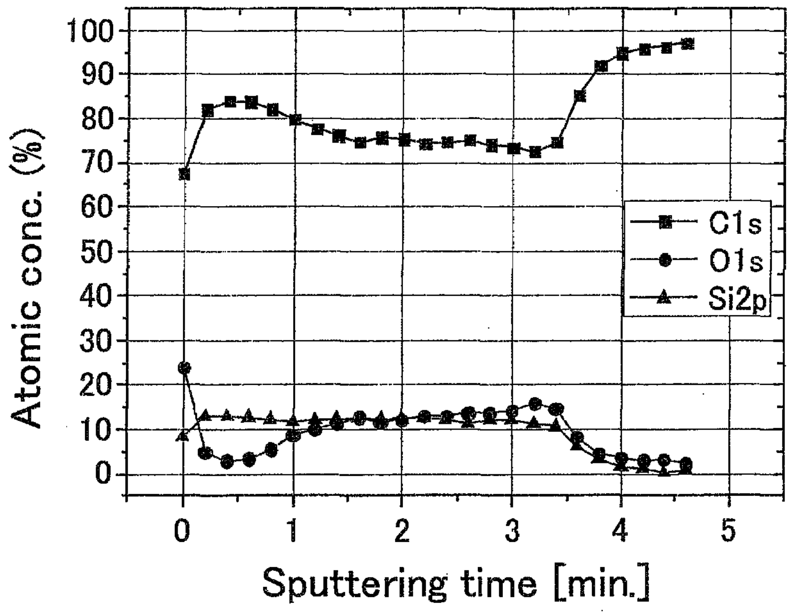
Atomic conc. (%)
100
90
80
70
60
50
40
30
20
10
0
0
1
2
3
4
5
Sputtering time [min.]
C1s
O1s
Si2p

FIG.3

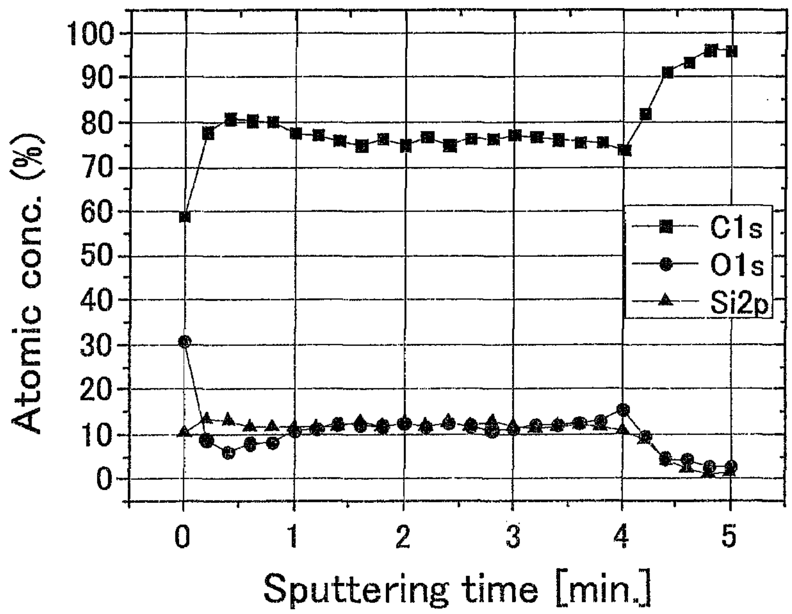
Atomic conc. (%)
100
90
80
70
60
50
40
30
20
10
0
0
1
2
3
4
5
Sputtering time [min.]
C1s
O1s
Si2p

FIG.4

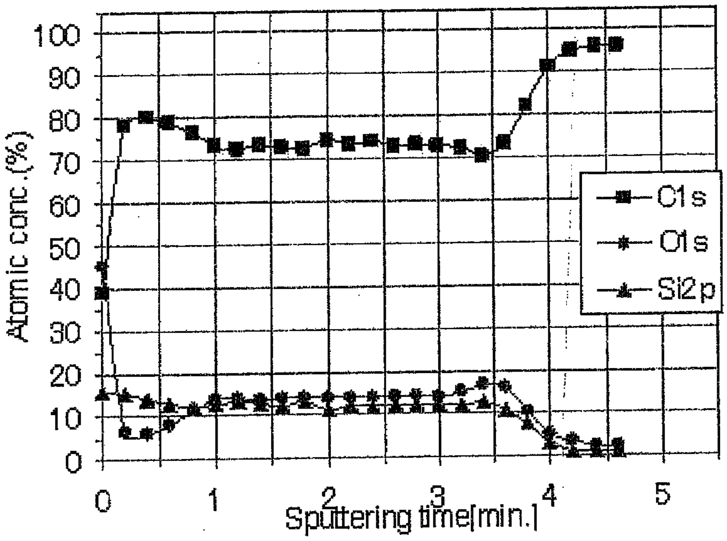
Atomic conc.(%)
100
90
80
70
60
50
40
30
20
10
0
0
1
2
3
4
5
Sputtering time[min.]
C1s
O1s
Si2p

FIG.5

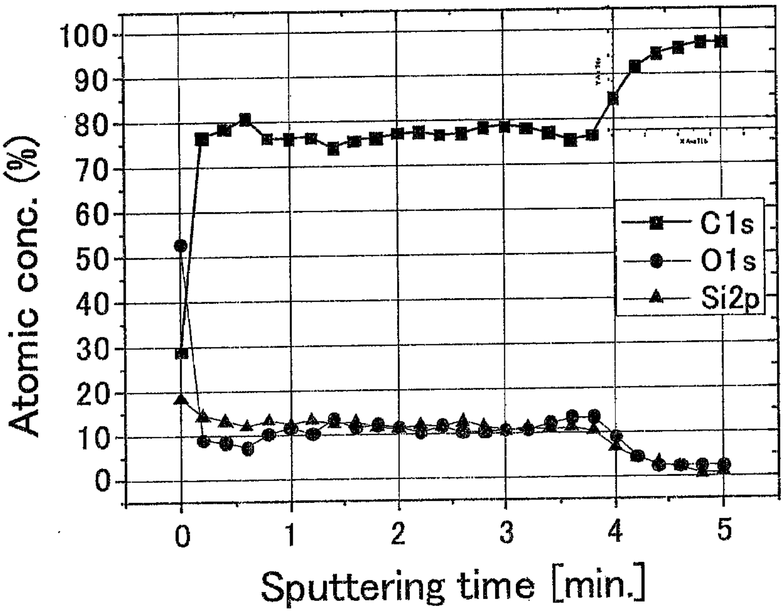
Atomic conc. (%)
100
90
80
70
60
50
40
30
20
10
0
0
1
2
3
4
5
Sputtering time [min.]
C1s
O1s
Si2p

FIG.6

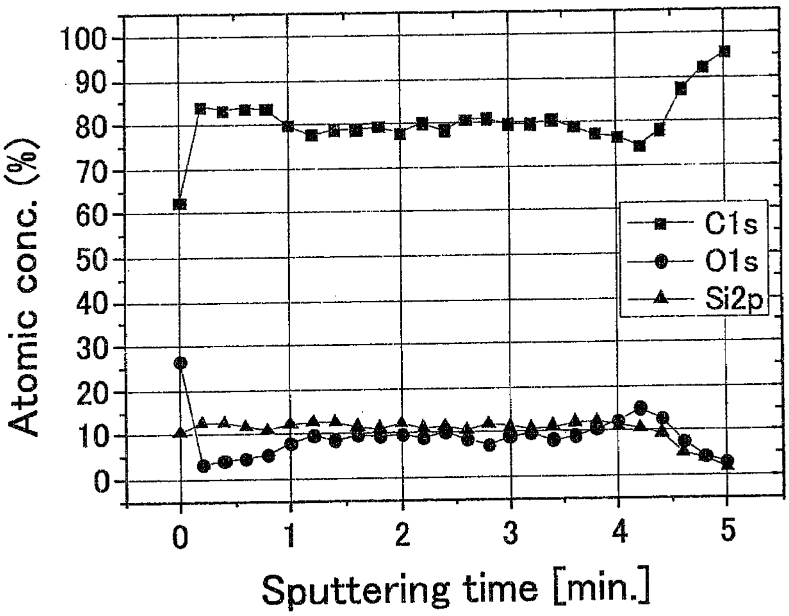
Atomic conc. (%)
100
90
80
70
60
50
40
30
20
10
0
0
1
2
3
4
5
Sputtering time [min.]
C1s
O1s
Si2p

FIG.7

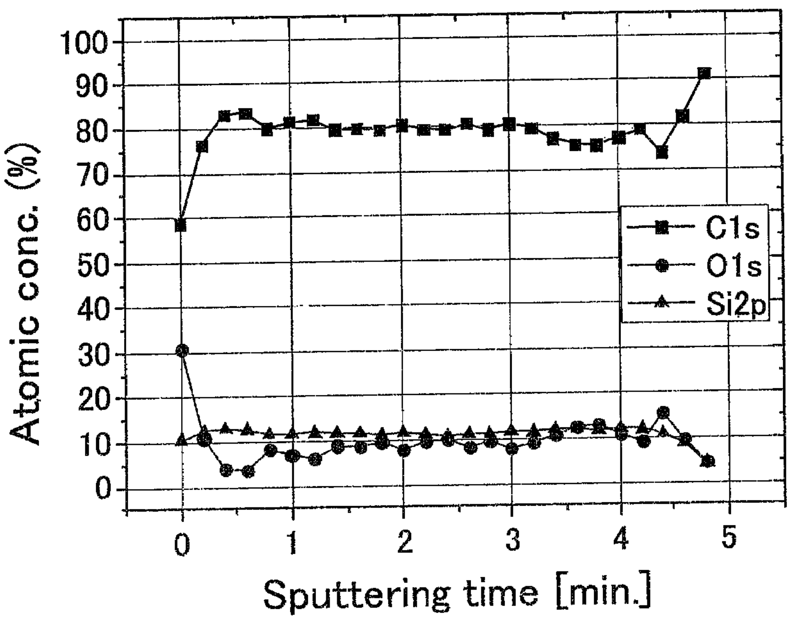
Atomic conc. (%)
100
90
80
70
60
50
40
30
20
10
0
0
1
2
3
4
5
Sputtering time [min.]
C1s
O1s
Si2p

FIG.8

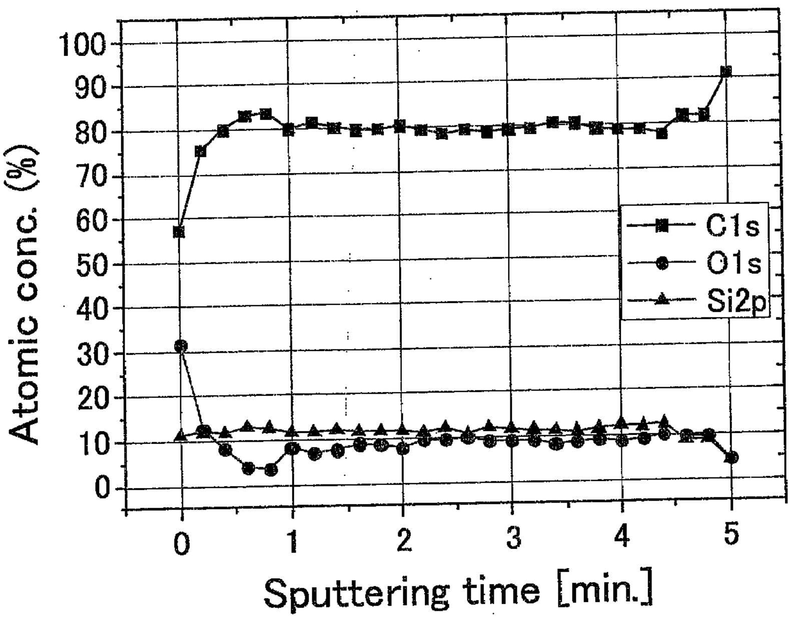
100
90
80
70
60
50
40
30
20
10
0
Atomic conc. (%)
C1s
O1s
Si2p
0
1
2
3
4
5
Sputtering time [min.]

FIG.9

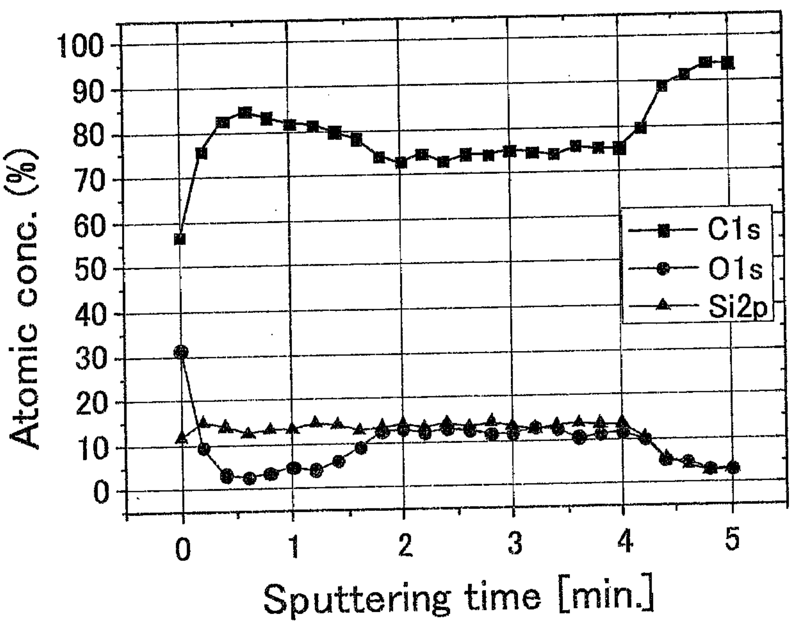
100
90
80
70
60
50
40
30
20
10
0
Atomic conc. (%)
C1s
O1s
Si2p
0
1
2
3
4
5
Sputtering time [min.]

FIG.10

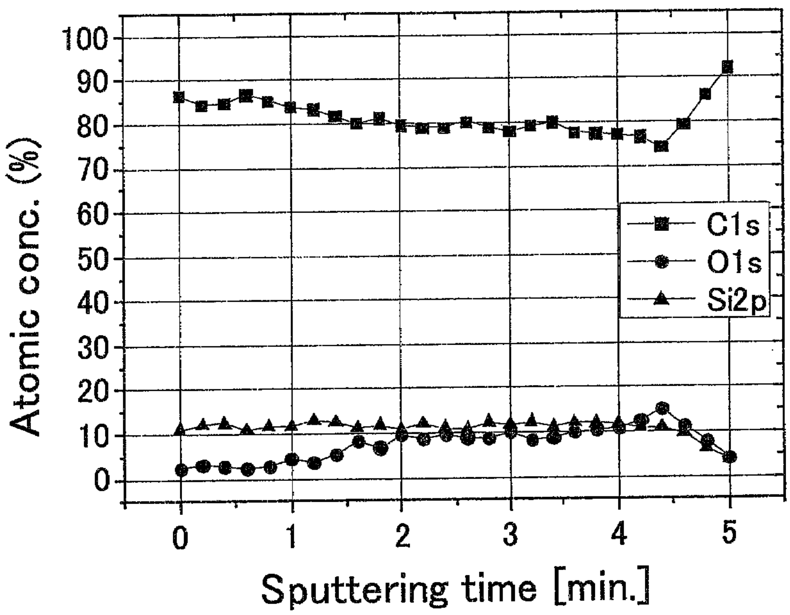
Atomic conc. (%)
100
90
80
70
60
50
40
30
20
10
0
0
1
2
3
4
5
Sputtering time [min.]
C1s
O1s
Si2p

**INTERNATIONAL SEARCH REPORT**

International application No.
PCT/JP2011/073538

**A. CLASSIFICATION OF SUBJECT MATTER**
*C23C14/48*(2006.01)i, *B32B27/16*(2006.01)i, *C08J7/00*(2006.01)i, *H01B5/14*(2006.01)i, *H01B13/00*(2006.01)i

According to International Patent Classification (IPC) or to both national classification and IPC

**B. FIELDS SEARCHED**

Minimum documentation searched (classification system followed by classification symbols)
C23C14/48, B32B27/16, C08J7/00, H01B5/14, H01B13/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)
JSTPlus(JDreamII)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 06-064105 A (Mitsui Toatsu Chemicals, Inc.), 08 March 1994 (08.03.1994), claims; paragraphs [0001], [0007], [0012], [0013]; examples; table 1 (Family: none) | 1,2,4,7-9, 13,14<br>3,5,6,10-12 |
| Y | WO 2010/021326 A1 (Lintec Corp.), 25 February 2010 (25.02.2010), claims; paragraphs [0095] to [0096] & KR 10-2011-0055546 A | 3,5,6,10-12 |
| A | JP 2010-232569 A (Lintec Corp.), 14 October 2010 (14.10.2010), claims (Family: none) | 1-14 |

☐ Further documents are listed in the continuation of Box C.    ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>06 January, 2012 (06.01.12) | Date of mailing of the international search report<br>24 January, 2012 (24.01.12) |
| Name and mailing address of the ISA/<br>Japanese Patent Office<br>Facsimile No. | Authorized officer<br><br>Telephone No. |

Form PCT/ISA/210 (second sheet) (July 2009)

**INTERNATIONAL SEARCH REPORT**

International application No.
PCT/JP2011/073538

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

The search, which has been carried out on the assumption that claims 1, 2, 4, 13 and 14 are deemed to be "first set forth invention (main invention)", revealed that the technical feature of the invention of claim 1 is not novel, since the technical feature is disclosed in the document 1 (JP 06-064105 A (Mitsui Toatsu Chemicals, Inc.), 8 March 1994 (08.03.1994), [claims], [0001], [0007], [0012], [0013], examples, table 1). Consequently, said technical feature cannot be considered to be a "special technical feature" within the meaning of PCT Rule 13.2, second sentence.

(continued to extra sheet)

1. ☐ As all required additional search fees were timely paid by the applicant, this international search report covers all searchable claims.
2. ☒ As all searchable claims could be searched without effort justifying additional fees, this Authority did not invite payment of additional fees.
3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

INTERNATIONAL SEARCH REPORT

International application No.
PCT/JP2011/073538

Continuation of Box No.III of continuation of first sheet(2)

Therefore, it is not considered that there is a technical relationship involving one or more of the same or corresponding special technical features between the main invention and the inventions in other claims.

Form PCT/ISA/210 (extra sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 8045352 A **[0007]**
- JP 6187833 A **[0007]**
- JP 2009199812 A **[0007]**
- WO 9829476 A **[0058]**
- JP 4334551 A **[0058]**
- JP 2001026887 A **[0119]**
- JP 2001156013 A **[0119]**
- WO 2010021326 A **[0120]**


### Non-patent literature cited in the description


- **R. D. MILLER ; J. MICHL.** *Chemical Review,* 1989, vol. 89, 1359 **[0056]**
- **N. MATSUMOTO.** *Japanese Journal of Physics,* 1998, vol. 37, 5425 **[0056]**
- *J. Am. Chem. Soc.,* 1988, vol. 110, 124 **[0058]**
- *Macromolecules,* 1990, vol. 23, 3423 **[0058]**
- *J. Chem. Soc., Chem. Commun.,* 1990, 1161 **[0058]**
- *J. Chem. Soc., Chem. Commun.,* 1992, 897 **[0058]**
- *Macromolecules,* 1990, vol. 23, 4494 **[0058]**